# EUROPÄISCHE PATENTSCHRIFT

(11) **EP 2 411 922 B1**
(45) Veröffentlichungstag und Bekanntmachung des Hinweises auf die Patenterteilung: **18.03.2015**
(21) Anmeldenummer: 09779210.5
(22) Anmeldetag: 26.03.2009
(51) Int. Cl.: G06F 13/40

(54) **ABSORBEREINHEIT FÜR EIN BUSSYSTEM**
ABSORBER UNIT FOR A BUS SYSTEM
UNITÉ ABSORBANTE POUR SYSTÈME DE BUS

(43) Veröffentlichungstag der Anmeldung: 01.02.2012
(73) Patentinhaber: Siemens Aktiengesellschaft, 80333 München (DE)
(72) Erfinder: WIESGICKL, Bernhard, 92249 Vilseck (DE); WIESGICKL, Stefan, 92249 Vilseck (DE)
(86) Internationale Anmeldenummer: PCT/EP2009/053593
(87) Internationale Veröffentlichungsnummer: WO 2010/108546

(56) Entgegenhaltungen:
- DE-A1-102006 048 109
- US-A- 5 684 831
- US-B1- 6 265 912

## Beschreibung

Die Erfindung betrifft eine Absorbereinheit zur Erhöhung der Störfestigkeit eines Systembusses. Innerhalb der industriellen Automatisierungstechnik werden zur Kommunikation zwischen Geräten anstelle der verdrahtungsaufwändigen Parallelverdrahtung auch Bussysteme, wie beispielsweise Ethernet, Profibus, Interbus, Modbus, AS-Interface Bus, etc., eingesetzt. Insbesondere das AS-Interface Bussystem ist bezüglich seiner Störfestigkeit gegen EMV-Beeinflussung (EMV = Elektromagnetische Verträglichkeit) für industrielle Umgebungen ausgelegt.

Die EMV-Beeinflussung kann durch eine konstruktive Gestaltung der Leitung des Bussystems minimiert werden, dennoch kommt es in einigen Anlagen zu überhöhten Störpegeln, welche die Buskommunikation so stark stören, dass die Kommunikation auf dem Bussystem zusammenbricht. Ein solcher Zusammenbruch ist sehr unerwünscht, da nahezu jede Unterbrechung der Buskommunikation zu Anlagestörungen führt und somit zu kostspieligen Fertigungsunterbrechungen führen kann. Dadurch, dass die überhöhten Störpegel meist sporadisch auftreten, ist eine Ursachenbeseitigung sehr schwierig und zeitaufwändig.

Die Offenbarung DE-A1-10 2006 048 109 beschreibt eine Absorbereinheit nach dem Präambel des unabhängigen Anspruchs 1.

Der Erfindung liegt daher die Aufgabe zugrunde, die Störfestigkeit eines Systembusses zu verbessern.

Die Lösung der gestellten Aufgabe gelingt durch eine Absorbereinheit zur Erhöhung der Störfestigkeit eines Systembusses nach dem unabhängigen Anspruch 1. Ein entsprechendes Verfahren wird in dem unabhängigen Anspruch 10 definiert.

Weitere vorteilhafte Ausführungsformen ergeben sich aus den Unteransprüchen.

Kommt es nun zu einer unerwünschten EMV-Beeinflussung des Systembusses, so können Störsignale, welche auf dem Systembus oberhalb des Kommunikationsfrequenzspektrums liegen, über den Hochpassfilters abgeleitet werden und mit Hilfe des Absorbierwiderstandes absorbiert werden. Negative Reflexionen, welche durch das Störsignal entstehen, können auf diese Weise vermieden werden. Der Systembus und somit ein Gesamtsystem, welches über den Systembus inklusive Absorbereinheit kommuniziert, wird somit hinsichtlich der Störfestigkeit enorm verbessert. Durch die Erfindung kann ein auf den Systembus eingekoppeltes Störspektrum bzw. Störsignal, welches außerhalb des Kommunikationsfrequenzspektrums liegt, reduziert werden und somit die Störfestigkeit des Gesamtsystems weiter verbessert werden. Üblicherweise werden in einem Empfangsdecoder, welcher an dem Systembus angeschlossen ist, Filtermaßnahmen zur Verbesserung der Signalqualität durchgeführt. Hierbei wird beispielsweise ein Tiefpassfilter vorgeschaltet, so dass ein unerwünschtes höherfrequentes Störspektrum nicht zu dem Empfangsdecoder gelangen kann. Eine derartige Unterdrückung des Störspektrums ist jedoch aus technischen und wirtschaftlichen Gründen nur mit einer endlichen Güte möglich, so dass weiterhin ein Handlungsbedarf hinsichtlich unerwünschter Störspektren besteht. Zudem liegt bei dem herkömmlichen Verfahren weiterhin das unerwünscht eingekoppelte Störspektrum vor. Durch die erfindungsgemäße Maßnahme werden dieser Nachteil behoben und die unerwünschten Störspektren wesentlich reduziert.

In einer vorteilhaften Ausführungsform der Erfindung liegt das Kommunikationsfrequenzspektrum zwischen 40 kHz und 500 kHz.

Ein solches Kommunikationsfrequenzspektrum wird beispielsweise bei AS-Interface Bussystemen verwendet. Ein EMV-Störspektrum ist im Normalfall viel hochfrequenter (bis über 100 MHz). Durch das verwendete Kommunikationsfrequenzspektrum kann somit eine stabile Kommunikation ermöglicht werden, ohne dass eine direkte Überlappung mit den üblicherweise auftretenden Störspektren vorliegt.

In einer weiteren vorteilhaften Ausführungsform der Erfindung stellt der Systembus einen AS-Interface Bus dar.

Durch die erfindungsgemäße Absorbereinheit kann der AS-Interface-Bus und somit ein gesamtes AS-Interface Bussystem bezüglich seiner Störfestigkeit gegen EMV-Beeinflussungen stark verbessert werden. Insbesondere für das AS-Interface-Bussystem, welches für die industrielle Umgebung ausgelegt ist, stellt dies eine enorme und wichtige Verbesserung dar. Stillstandszeiten, sowie Kommunikationsfehler können in der industriellen Umgebung fatale Folgen haben. Durch die erfindungsgemäße Absorbereinheit wird ein wesentlicher Beitrag zur Verbesserung der Störfestigkeit eines Systembusses geleistet.

In einer weiteren Ausführungsform der Erfindung ist die Absorbereinheit durch einen gedämpften Serienschwingkreis ausgebildet.

Dadurch, dass hochfrequente Störungen über einen Hochpassfilter, in diesem Ausführungsbeispiel ein Serienschwingkreis, auf einen Absorberwiderstand geleitet werden, kann die hochfrequente Störung besser abgeleitet und absorbiert werden. Der Schwingkreis hat im Vergleich zum Hochpass erster Ordnung einen steileren Verlauf seiner Übertragungsfunktion, was sich positiv auf das beschriebene Szenario auswirkt. Hierbei sollte der Hochpassfilter so dimensioniert sein, dass er das verwendete Kommunikationsfrequenzspektrum nicht beeinflusst.

In einer weiteren Ausführungsform der Erfindung liegt eine Resonanzfrequenz des gedämpften Serienschwingkreises zwischen 6 bis 10 MHz, vorzugsweise bei 8 MHz.

Auf diese Meiste kann ein optimales Filtern und Absorbieren der unerwünschten hochfrequenten Störsignale insbesondere bei AS-Interface Bussystemen erfolgen.

In einer vorteilhaften Ausgestaltung der Erfindung ist eine erfindungsgemäße Absorbereinheit in dem Master integriert, wobei der Master für die Kommunikation auf dem Systembus ausgelegt ist.

Hierdurch kann die Absorbereinheit in eine bestehende Systemkomponente integriert werden, so dass keine zusätzliche Komponente am Systembus angebracht werden muss. Des Weiteren ist die Absorbereinheit an einem Ende des Systembusses angebracht, so dass die Reflexionen des Störsignals, welche üblicherweise an einem Ende des Systembusses entstehen, direkt über die Absorbereinheit abgeleitet und absorbiert werden können.

In einer weiteren Ausführungsform der Erfindung ist die Absorbereinheit in einem Netzteil, welches für den Systembus ausgelegt ist, integriert.

Hierbei ergeben sich die gleichen Vorteile wie bei der Integration der Absorbereinheit in die Mastereinheit.

In einer weiteren Ausführungsform der Erfindung ist die Absorbereinheit im Wesentlichen an einem Ende des Systembusses an diesem angeschlossen.

Hierdurch kann ein sicheres Ableiten und Absorbieren der Störsignale auf dem Systembus erfolgen, so dass die Reflexionen des Störsignals, welche üblicherweise an einem Ende des Systembusses entstehen, direkt über die Absorbereinheit abgeleitet werden können.

In einer weiteren Ausführungsform der Erfindung ist die Absorbereinheit in der Nähe einer Störquelle an dem Systembus angeschlossen.

Dies hat den Vorteil, dass die Störsignale direkt an der "Quelle" über die Absorbereinheit abgeleitet und absorbiert werden können. Die Störsignale können sich somit nicht über den Systembus verteilen.

Im Folgenden werden die Erfindung und Ausgestaltungen der Erfindung anhand der in den Figuren dargestellten Ausführungsbeispiele näher beschrieben und erläutert. Es zeigen:
- FIG 1: einen schematischen Aufbau eines Bussystems,
- FIG 2: einen zweiadrigen Systembus, welcher eine Absorbereinheit aufweist und
- FIG 3: eine schematische Darstellung einer Absorbereinheit als gedämpfter Serienschwingkreis.

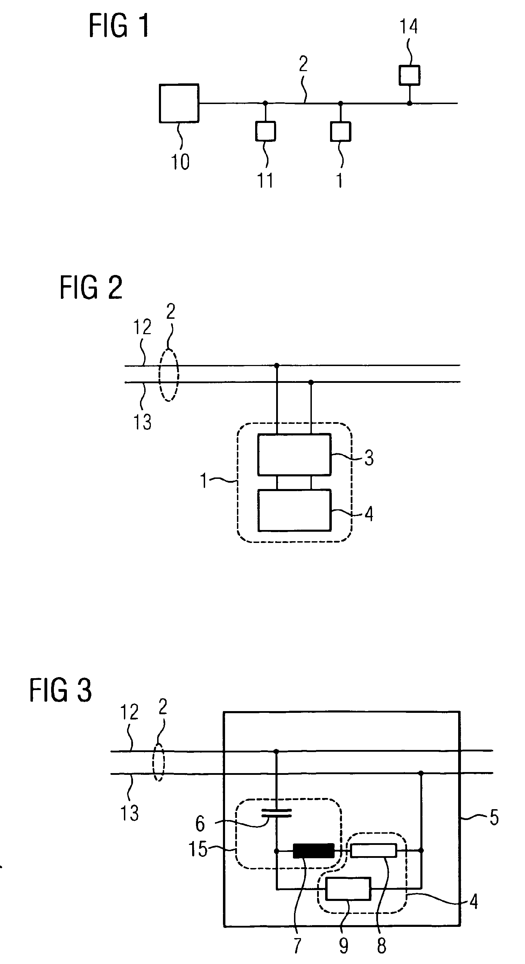

In FIG 1 weist ein Bussystem einen Master 10, ein Netzteil 11, einen Slave 14, sowie eine Absorbereinheit 1 auf. Alle Komponenten 10, 11, 14, 1 sind über einen Systembus 2 miteinander verbunden. Werden nun unerwünschte Störsignale auf dem Systembus 2 eingekoppelt und übertragen, so kann mit Hilfe der Absorbereinheit 1 das Störsignal herausgefiltert und absorbiert werden. Hierbei wird über einen Hochpassfilter, welcher eingangsseitig mit dem Systembus 2 verbunden ist, das Störsignal, sofern es oberhalb eines Kommunikationsfrequenzspektrums des verwendeten Bussystems liegt, abgeleitet und an einen Absorberwiderstand weitergeleitet. Dieser Absorberwiderstand absorbiert letztendlich das unerwünschte Störsignal. Das Störsignal wird somit direkt von dem Systembus abgeleitet, so dass es zu keiner Kommunikationsbeeinträchtigung auf dem Systembus durch das Störsignal kommt. Dies stellt insbesondere im Umfeld der industriellen Automatisierungstechnik einen enormen Vorteil dar.

FIG 2 zeigt einen zweiadrigen Systembus 2, welcher eine Absorbereinheit 1 aufweist. Dieser zweiadrige Systembus 2 stellt in diesem Ausführungsbeispiel einen AS-Interface Bus 2 dar. Hierbei weist der AS-Interface-Bus 2 eine +Leitung 12 sowie eine -Leitung 13 auf. An dem AS-Interface Bus 2 ist eine Absorbereinheit 1 angeschlossen. Die Absorbereinheit 1 ist über einen Hochpassfilter 3 mit dem AS-Interface Bussystem 2 verbunden. Dieser Hochpassfilter 3 ist derart dimensioniert, dass er für Störsignale, welche oberhalb des verwendeten Kommunikationsfrequenzspektrums liegen, niederimpedant ist und so die hochfrequenten Signale an einen Absorberwiderstand 4 weiterleitet. Diese hochfrequenten Störsignale können somit von der Absorbereinheit 4 absorbiert werden. Auf diese Weise können unerwünschte Störsignale, welche oberhalb des verwendeten Kommunikationsfrequenzspektrums liegen, auf dem AS-Interface Bus 2 über die Absorbereinheit 1 abgeleitet und absorbiert werden, so dass unerwünschte Störsignale auf dem AS-Interface Bus 2 reduziert werden. Hierdurch wird die Störfestigkeit des AS-Interface Bussystems enorm verbessert. Die Kommunikationszuverlässigkeit sowie die Belastbarkeit des AS-Interface Bussystems wird stark verbessert.

FIG 3 zeigt eine schematische Darstellung einer Absorbereinheit als stark gedämpfter Serienschwingkreis 5. Der Systembus 2 stellt hierbei einen AS-Interface Bus dar. Dieser AS-Interface Bus 2 weist eine +Leitung 12 sowie eine -Leitung 13 auf. Um unerwünschte Störsignale auf dem AS-Interface Bus 2 abzugreifen, wird hierbei ein stark gedämpfter Serienschwingkreis 5 eingesetzt. Dieser stark gedämpfte Serienschwingkreis 5 besteht aus einem Hochpassfilter, welcher in diesem Ausführungsbeispiel durch einen Schwingkreis 15 realisiert ist, und einem Absorberwiderstand 4. Der Serienschwingkreis 15 ist mit einer Resonanzfrequenz von ca. 8 MHz ausgeführt. Der Serienschwingkreis 15 wird hierbei durch einen Kondensator 6 mit 68 pF und einer Spule 7 mit 5,6 uH gebildet. Als Absorberwiderstand 4 sind hierbei ein erster Widerstand 8 mit 47 Ohm und ein zweiter Widerstand mit 470 Ohm aufgeführt. Mehrere Versuche haben ergeben, dass durch einen stark gedämpften Serienschwingkreis 5 in einer solchen Konstellation ein optimales Ergebnis für einen AS-Interface Bus 2 hinsichtlich der Beseitigung unerwünschter Störsignale auf dem AS-Interface Bus 2 erzielt wird.

## Patentansprüche

1. Absorbereinheit (1) zur Erhöhung der Störfestigkeit eines Systembusses (2), wobei der Systembus (2) dazu ausgelegt ist, dass in einem definierten Kommunikationsfrequenzspektrum kommuniziert werden kann, wobei die Absorbereinheit (1) einen Hochpassfilter (3) und einen Absorberwiderstand (4) umfasst, wobei der Hochpassfilter (3) eingangsseitig mit dem Systembus (2) und ausgangseitig mit dem Absorberwiderstand (3) verbindbar ist und derart dimensioniert ist, dass er für Störsignale, welche oberhalb des Kommunikationsfrequenzspektrums liegen, niederimpedant ist, so dass diese von dem Absorberwiderstand (3) absorbiert werden, **dadurch gekennzeichnet, dass** die Absorbereinheit (1) durch einen gedämpften Serienschwingkreis (5) ausgebildet ist.

2. Absorbereinheit (1) nach einem der vorhergehenden Ansprüche, wobei das Kommunikationsfrequenzspektrum zwischen 40 kHz und 500 kHz liegt.

3. Absorbereinheit (1) nach einem der vorhergehenden Ansprüche, wobei der Systembus (2) ein AS-Interface Bus darstellt.

4. Absorbereinheit (1) nach einem der vorhergehenden Ansprüche, wobei die Absorbereinheit (1) durch einen stark gedämpften Serienschwingkreis (5) ausgebildet ist.

5. Absorbereinheit nach Anspruch 4, wobei eine Resonanzfrequenz des stark gedämpften Serienschwingkreises (5) zwischen 6 MHz bis 10 MHz, vorzugsweise bei 8 MHz liegt.

6. Master (10) mit einer Absorbereinheit (1) nach einem der Ansprüche 1 bis 5, wobei die Absorbereinheit (1) in dem Master (10), welcher für die Kommunikation auf dem Systembus (2) ausgelegt ist, integriert ist.

7. Netzteil (11) mit einer Absorbereinheit (1) nach einem der Ansprüche 1 bis 5, wobei die Absorbereinheit (1) in dem Netzteil (11), welches für den Systembus (2) ausgelegt ist, integriert ist.

8. Systembus (2) mit einer Absorbereinheit (1) nach einem der Ansprüche 1 bis 5, wobei die Absorbereinheit (1) im Wesentlichen an einem Ende des Systembusses (2) an diesem angeschlossen ist.

9. Systembus (2) mit einer Absorbereinheit (1) nach einem der Ansprüche 1 bis 5, wobei die Absorbereinheit (1) in der Nähe einer Störquelle an dem Systembus (2) angeschlossen ist.

10. Verfahren zur Erhöhung der Störfestigkeit eines Systembusses (2), wobei in einem definierten Kommunikationsfrequenzspektrum auf dem Systembus (2) kommuniziert wird, wobei ein Hochpassfilter (3) eingangsseitig mit dem Systembus (2) verbunden wird und ausgangseitig mit einem Absorberwiderstand (4) verbunden wird und derart dimensioniert wird, dass er für Störsignale, welche oberhalb des Kommunikationsfrequenzspektrums liegen, niederimpedant ist, so dass die Störsignale von dem Absorberwiderstand (4) absorbiert werden, wobei die Absorbereinheit (1) durch einen gedämpften Serienschwingkreis (5) ausgebildet ist.

## Claims

1. Absorber unit (1) for increasing the noise immunity of a system bus (2), wherein the system bus (2) is designed to enable communication to take place in a defined communication frequency spectrum, wherein the absorber unit (1) comprises a high-pass filter (3) and an absorber resistor (4), wherein the high-pass filter (3) can be connected to a system bus (2) on the input side and to the absorber resistor (4) on the output side and is dimensioned such that it has a low-impedance effect for noise signals that lie above the communication frequency spectrum so that said signals are absorbed by the absorber resistor (4), **characterised in that** the absorber unit (1) is embodied by an attenuated series resonant circuit (5).

2. Absorber unit (1) according to one of the preceding claims, wherein the communication frequency spectrum lies between 40 kHz and 500 kHz.

3. Absorber unit (1) according to one of the preceding claims, wherein the system bus (2) represents an AS-Interface bus.

4. Absorber unit (1) according to one of the preceding claims, wherein the absorber unit (1) is embodied by a strongly attenuated series resonant circuit (5).

5. Absorber unit according to claim 4, wherein a resonant frequency of the strongly attenuated series resonant circuit (5) lies between 6 MHz to 10 MHz, preferably at 8 MHz.

6. Master (10) having an absorber unit (1) according to one of claims 1 to 5, wherein the absorber unit (1) is integrated in the master (10), which is configured for communication on the system bus (2).

7. Power supply (11) having an absorber unit (1) according to one of claims 1 to 5, wherein the absorber unit (1) is integrated in the power supply (11), which is configured for the system bus (2).

8. System bus (2) having an absorber unit (1) according to one of claims 1 to 5, wherein the absorber unit (1) is essentially connected to the system bus (2) at one end thereof.

9. System bus (2) having an absorber unit (1) according to one of claims 1 to 5, wherein the absorber unit (1) is connected to the system bus (2) in the vicinity of a source of interference.

10. Method for increasing the noise immunity of a system bus (2), wherein communication takes place in a defined communication frequency spectrum on the system bus (2), wherein a high-pass filter (3) is connected to the system bus (2) on the input side and to an absorber resistor (4) on the output side and is dimensioned such that it has a low-impedance effect for noise signals that lie above the communication frequency spectrum so that said noise signals are absorbed by the absorber resistor (4), wherein the absorber unit (1) is embodied by an attenuated series resonant circuit (5).

## Revendications

1. Unité ( 1 ) d'absorption pour augmenter la résistance aux parasites d'un bus ( 2 ) de système, le bus ( 2 ) de système étant conçu pour pouvoir communiquer dans un spectre défini de fréquences de communication, l'unité ( 1 ) d'absorption comprenant un filtre ( 3 ) passe-haut et une résistance ( 4 ) d'absorption, le filtre ( 3 ) passe-haut pouvant être relié du côté de l'entrée au système ( 2 ) de bus et du côté de la sortie à la résistance ( 3 ) d'absorption et ayant des dimensions telles qu'il est à basse impédance pour des signaux parasites qui sont au-dessus du spectre de fréquence de communication de manière à ce que ceux-ci soient absorbés par la résistance ( 3 ) d'absorption, **caractérisée en ce que** l'unité ( 1 ) d'absorption est constituée par un circuit ( 5 ) oscillant série amorti.

2. Unité ( 1 ) d'absorption suivant l'une des revendications précédentes, dans laquelle le spectre de fréquence de communication est compris entre 40 kHz et 500 kHz.

3. Unité ( 1 ) d'absorption suivant l'une des revendications précédentes, dans laquelle le bus ( 2 ) de système représente un bus d'interface AS.

4. Unité ( 1 ) d'absorption suivant l'une des revendications précédentes, dans laquelle l'unité ( 1 ) d'absorption est constituée par un circuit ( 5 ) oscillant série très amorti.

5. Unité ( 1 ) d'absorption suivant la revendication 4, dans laquelle une fréquence de résonance du circuit ( 5 ) oscillant série très amorti est comprise entre 6 MHz et 10 MHz, en étant de préférence de 8 MHz.

6. Mètre ( 10 ) ayant une unité ( 1 ) d'absorption suivant l'une des revendications 1 à 5, l'unité ( 1 ) d'absorption étant intégrée au maître ( 10 ) qui est conçu pour la communication sur le bus ( 2 ) de système.

7. Alimentation ( 11 ) ayant une unité ( 1 ) d'absorption suivant l'une des revendications 1 à 5, dans laquelle l'unité ( 1 ) d'absorption est intégrée à l'alimentation ( 11 ) qui est conçue sur le bus ( 2 ) de système.

8. Bus ( 2 ) de système ayant une unité ( 1 ) d'absorption suivant l'une des revendications 1 à 5, l'unité ( 1 ) d'absorption étant raccordée au bus ( 2 ) de système sensiblement à une extrémité de celui-ci.

9. Bus ( 2 ) de système ayant une unité ( 1 ) d'absorption suivant l'une des revendications 1 à 5, l'unité ( 1 ) d'absorption étant raccordée au bus ( 2 ) de système à proximité d'une source de parasites.

10. Procédé d'augmentation de la résidence aux parasites d'un bus ( 2 ) de système, dans lequel on communique sur le bus ( 2 ) de système dans un spectre défini de fréquences de communication, on relie un filtre ( 3 ) passe-haut du côté de l'entrée au système ( 2 ) de bus et du côté de la sortie à une résistance ( 4 ) d'absorption et on le dimensionne de manière à ce qu'il soit à basse impédance pour des signaux parasites qui sont au-dessus du spectre de fréquence de communication de manière à absorber les signaux parasites par la résistance ( 4 ) d'absorption, l'unité ( 1 ) d'absorption étant constituée par un circuit ( 5 ) oscillant série amorti.
